# EUROPEAN PATENT SPECIFICATION

(11) **EP 0 481 727 B1**
(45) Date of publication and mention of the grant of the patent: **06.04.1994**
(21) Application number: 91309482.7
(22) Date of filing: 15.10.1991
(51) Int. Cl.: H05K 7/10

(54) **Socket for electric part**
Sockel für ein elektrisches Teil
Douille pour une pièce électrique

(30) Priority: 17.10.1990 JP 278461/90
(43) Date of publication of application: 22.04.1992
(73) Proprietor: YAMAICHI ELECTRONICS CO., LTD., Ohta-ku, Tokyo (JP)
(72) Inventor: Uratsuji, Kazumi, Tokyo (JP)
(74) Representative: Wood, Anthony Charles

(56) References cited:
- EP-A- 0 118 346
- EP-A- 0 295 046
- EP-A- 0 390 543
- US-A- 4 623 208
- US-A- 4 886 470

## Description

### 1. FIELD OF THE INVENTION

This invention relates to a zero insertion type socket for an electric part including a means for displacing a contact between a contacted position and a released position.

### 2. BRIEF DESCRIPTION OF THE PRIOR ART

In a conventional socket represented by US-A-4 623 208 a contact itself includes a cantilevered arm projecting outwardly. When the cantilevered arm is pushed down with a presser cover, a curved spring portion, which is provided to the contact itself, is flexed in the compressing direction to realize an outward displacement as a component of force, thereby to separate a contact nose portion away from a contact of an IC, so that the IC can be inserted and removed with no load.

In the above-mentioned conventional IC socket, the operational force for pushing down the presser cover and the contacting force of the contact are determined by the spring portion of the contact.

Accordingly, if a spring constant of the spring portion is increased in order to increase the contacting force, the operational force for pushing down the presser cover is also increased. On the contrary, if the spring constant of the spring portion is reduced in order to reduce the operational force, the contacting force is also reduced. The conventional IC socket had such incompatible problems as just mentioned. Therefore, it was difficult for the conventional IC socket to be such designed as to satisfy both the requirements for reducing the operational force as much as possible and increasing the contacting force.

The constitution where the spring portion is compressed in order to obtain an outward displacement motion by pushing down the cantilevered arm has such inconveniences as that the outward displacement amount realized as a component of force relative to the pushing down amount is very limited, and an efficient amount of displacement is unobtainable relative to the pushing down amount.

It has also such inconveniences as that when the cantilevered arm is pushed down, the axis of the contact tends to be twisted, an undesirable shifting is generated to the contact nose portion, and a metal fatigue tends to be accumulated in the basal portion of the cantilevered arm when an external force is repeatedly exerted to the cantilevered arm in the curved direction.

In the conventional contact, various complicated designing requirements or conditions must be satisfied, such as setting of a sectional area for providing a certain strength, setting of the spring constant, counter-measure for twisting, etc.

### SUMMARY OF THE INVENTION

It is therefore an object of the present invention to provide a socket for an electric part capable of reducing the pushing down operational force and increasing the contacting force.

Another object of the present invention is to provide a socket for an electric part capable of causing an efficient outward displacement upon pushing down operation and thus, capable of obtaining a sufficient amount of outward displacement with a limited pushing down amount.

A further object of the present invention is to provide a socket for an electric part capable of solving such problems as twisting of a contact resulting from a pushing down operation and metal fatigue of a cantilevered arm, and of soundly displacing the contact even if the socket is used repeatedly.

To achieve the above objects, there is provided a socket for an electric part including a lever pivotable, about an axis parallel to a row of contacts and pivotably supported along, said row of contacts each including a contact arm portion and a curved spring portion, an operating portion formed on one end of said pivotable lever and adapted to operate said pivotable lever upwardly and downwardly, and an acting portion formed on the other end thereof and adapted to exert an outward force to said contact, said acting portion, when said pivotable lever is pivoted downwardly by said operating portion, displacing said contact arm portion of said contact outwardly against the resiliency of said spring portion so that the contact arm portion is separated away from the contact of said electric part to facilitate a no-load insertion of said electric part.

In the socket for an electric part according to the present invention, a pushing down force is exerted to the operating portion of the pivotable lever. The operating portion can be directly pushed down by robot or finger. It may also be designed such that the socket includes a vertically movable presser cover as had in the prior art, and the pivotable lever is indirectly pushed down by pushing down the presser cover by robot or finger.

When the operating portion is pushed down, the pivotable lever is pivoted downwardly about an axial line parallel to the row of contacts and as a result, an outward force is exerted to the contact by the acting portion. As a result, the contact is displaced outwardly against the resiliency of the spring portion and separated away from the contact of the electric part accommodated in the electric part accommodating space to release the electric part. Therefore, the electric part can be removed or inserted with no-load.

When the pushing down force exerted to the operating portion is released, the pivotable lever is pivoted upwardly by resiliency of the spring portion of the contact exerted to the acting portion or by resiliency of another spring portion resiliently holding the pivotable lever and then waits for the next pushing down operation. At the same time, the contact is displaced inwardly by being biased by spring portion and brought into contact with the contact of the electric part under pressure.

In the above-mentioned socket for an electric part, the spring portion of the contact can be arranged to have such a spring constant as being contacted with the contact of the electric part with a proper contacting force. On the other hand, the pivotable lever can be pushed down with a reduced operational force in accordance with the principle of lever. Even if the spring constant of the spring portion of the contact is set large, this is not directly resulted in increase of the pushing down force, and the pushing down force can be reduced by properly setting the distances of the operating portion and acting portion from the pivotal fulcrum of the pivotable lever. At the same time, the object for increasing the contacting force can also be achieved.

Furthermore, since the acting portion of the pivotable lever exerts an outward force directing in the same direction as the displacement to the contact to cause the contact to be separated away from the contact of an electric part, the outward displacement of the contact can efficiently be realized relative to the pushing down force of the pivotable lever, and a sufficient space for accommodating the electric part can be released.

Moreover, such unfavorable problems as twisting of the contact and an accumulation of metal fatigue in the cantilevered arm as had in the prior art where the cantilever arm of the contact is pushed down are not arisen, and the contact can be soundly displaced even if the socket is repeatedly used.

The above and other objects and attendant advantages of the present invention will be readily apparent to those skilled in the art from a reading of the following detailed description in conjunction with the accompanying drawings which show preferred embodiments of the present invention.

### BRIEF DESCRIPTION OF THE DRAWINGS

Figs. 1 through 4 show the first embodiment of the present invention, wherein:
Fig. 1 is a perspective view showing an outer appearance of a socket for an electric part;
Fig. 2 is a perspective view showing an outer appearance of the socket for an electric part having a presser cover;
Figs. 3(A), 3(B) and 3(C) are sectional views of an important part of the socket for an electric part, showing operating states of a pivotable lever and a contact; and
Figs. 4(A), 4(B) and 4(C) are sectional views of an important part of the socket for an electric part having a presser cover, showing operating states thereof;
Figs. 5(A) and 5(B) are sectional views of an important part of a socket for an electric part according to the second embodiment of the present invention, showing operating states thereof;
Figs. 6(A) and 6(B) are sectional views of an important part of a socket for an electric part according to the third embodiment of the present invention, showing operating states thereof; and
Fig. 7 is a sectional view of an important part of the socket for an electric part according the fourth embodiment of the present invention.

### DETAILED DESCRIPTION OF THE EMBODIMENT

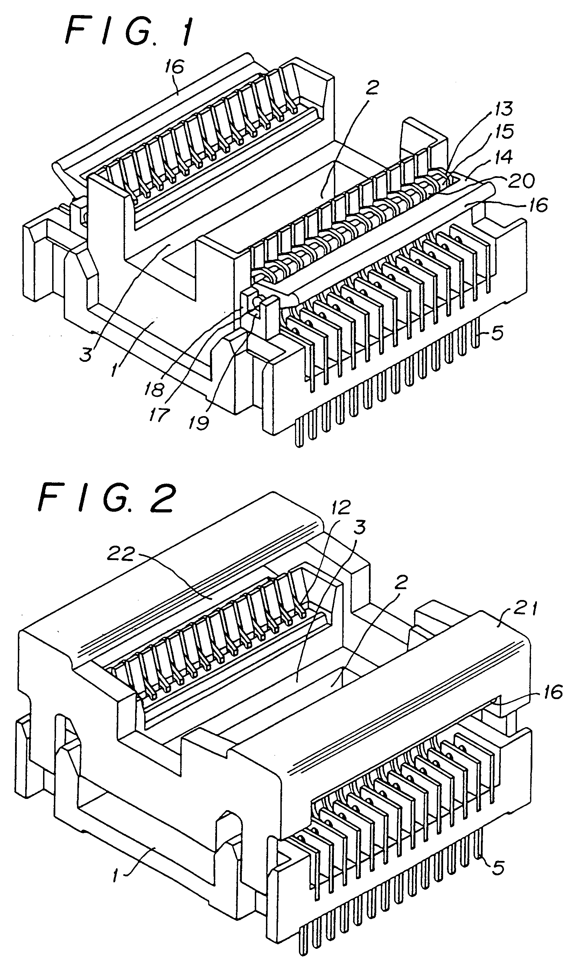

Several embodiments of the present invention will be described hereinafter in detail with reference to Figs. 1 through 7 of the accompanying drawings.

### FIRST EMBODIMENT (SEE FIGS. 1 THROUGH 4)

This embodiment provides a closed type socket previously mentioned.

A base member 1 formed of an insulated material has a central opening 2 through its upper and lower surfaces. A space 3 for accommodating an electric part is defined on the upper surface side of the central opening 2. The base member 1 is provided with a plurality of contacts arranged in parallel relation along at least two opposed sides of the space 3.

The contacts 4 are implanted in the base member 1. Each contact 4 includes a male terminal 5 extending downward from a lower surface of the base member 1. The contact 4 also includes a flat portion 6 connected next to a basal portion of the male terminal 5. The flat portion 6 is supported on and vertically erected from an upper surface of an implanted wall of the contact. The contact 4 further includes a spring portion 7 connected next to an inner edge of an upper end of the flat portion 6. The spring portion 7 has a curved shape extending downward from its connected portion (basal portion 8) with the flat portion 6 and then curved back to the vicinity of the connected portion. In other words, the spring portion 7 has a downwardly directed curved shape. An angle of the curve is set such that a predetermined small distance 10 is formed between the basal portion 8 and a distal end 9 of the spring portion 7 extending from the basal portion 8. This angle of the curve is preferably set to 180 degrees or more, and more preferably to 250 degrees or more. In other words, the spring portion 7 is curved such that the distal end 9 thereof reaches the vicinity of an upper end of a vertical center line Y of the curved spring portion 7. The contact 4 further includes a contact arm 11 connected next to the distal end 9 of the curved spring portion 9 and inclining inwardly. The contact arm 11 terminates in a contact nose projecting inwardly and and downwardly from its distal end.

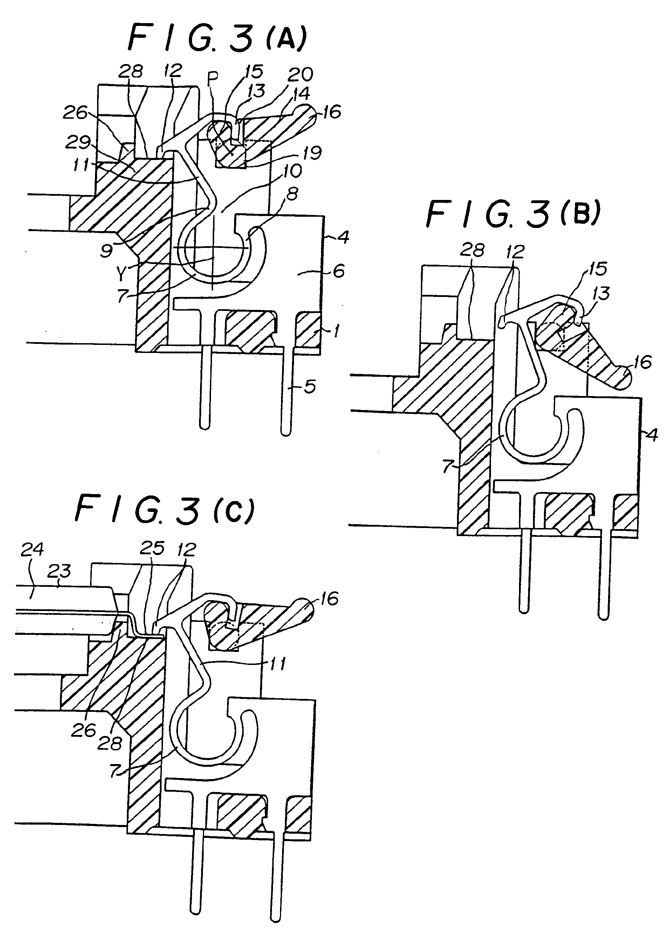

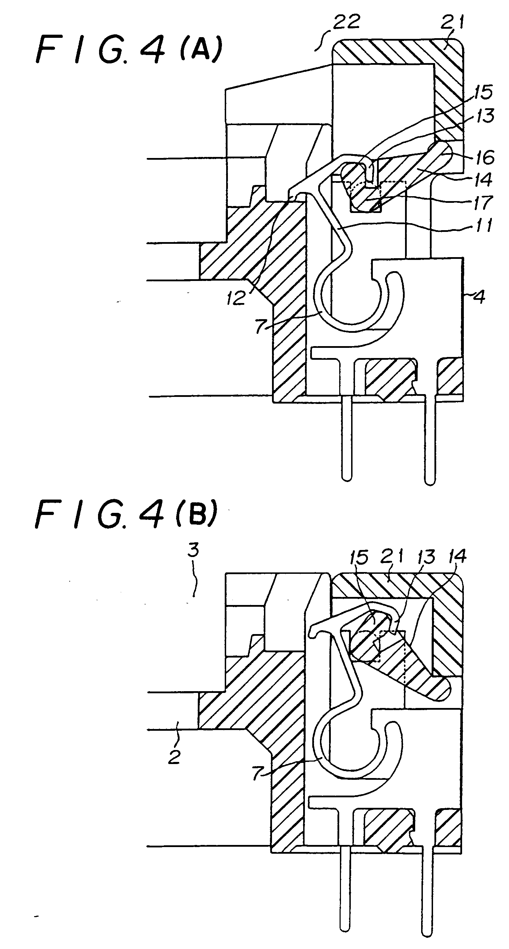

As shown in Figs. 3(A) and 4(A), the spring portion 7 urges the contact arm 11 and the contact nose 12 inwardly so that the contact nose 12 is brought into contact with a contact 25 of an electric part 23. The contact 4 further includes a latch portion 12 extending outwardly and upwardly from the distal end of the arm 11, that is, from the connected portion between the arm 11 and the contact nose 12. An acting portion 15 of the pivotable lever 14 is brought into engagement with a free end of the latch portion 13. The latch portion 13 and the contact nose 12 are disposed at an free end of the contact and extending in opposite directions with each other.

As shown in Fig. 1, the pivotable lever 14 is extended in parallel relation with a row of the contacts 4. The pivotable lever 14 is provided with an operating portion 16 extending outward from one end side thereof and with the acting portion 15 formed on the other end side thereof and engageable with the latch portion 13. The pivotable lever 14 and its operating and acting portions 16 and 13 are extended in such a manner as to be parallel with the row of the contacts 4 at outside of the contact arm 11, and are vertically pivotable about an axis P parallel with the row of the contacts 4. The pivotable lever 14 is provided with a shaft portion 17 projecting toward the axial line P from both ends thereof, and the shaft portion 17 is rotatably carried on a bearing portion 18 formed on the base member 1. The pivotal fulcrum formed by the shaft portion 17 is located at the outer side of the contact arm 11. The shaft portion 18 defines a recess portion 19 opened up upwardly. The shaft portion 17 is sliding fitted in the recess portion 19, so that the pivotable lever 14 can be removed upwardly from the recess portion 19 and inserted into the recess portion 19 from above.

The pivotable lever 14 is provided with an engaging groove 20 formed in an upper surface of the acting portion 15 of thereof and extending in parallel with the row of the contacts 4. A hooked tip of the latch 13 of the contact 4 is slightly loosely inserted into the engaging groove 20 so that the latch portion 13 is engaged with the acting portion 15 and an outward force is exerted thereto. More specifically, all of the latch group of the group of contacts arranged in a row are brought into engagement in the elongated engaging groove 20. The position where the acting portion 15 of the pivotable lever 14 acts on the latch portion 13 is higher than the contacting position of the contact nose 12 projecting inwardly from the distal end of the contact arm 11. As described above, the latch portion 13 is projected outwardly and upwardly from the distal end of the contact arm 11, thereby setting the acting portion 15 in a higher position than the contact nose portion 12.

The pivotable lever 14 is integrally formed of an insulated material and includes the above-mentioned various component elements 15, 16, 20 and 17. Although not illustrated, a plurality of pivotable levers 14 may be employed for each row of the contacts 4. In other words, it may be designed such that the group of contacts 4 arranged in a row is further divided into small groups of contacts 4, and such divided small groups of contacts 4 are displaced by separate pivotal levers.

In the embodiment shown in Figs. 1 through 4, the pivotable lever 14 is supported by the axial line P so that it is pivoted about the fixed fulcrum. This pivotal fulcrum is located behind the contact arm 11 as previously mentioned. The pivotable lever 14, as shown in Figs. 1 through 3, may be designed such that the operating portion 16 is directly pushed down by robot or finger, without a provision of a presser cover. Also, as shown in Figs. 2 and 4, a presser cover 21 is disposed over the base member 1. The presser cover 21 is provided with a central window 22 facing with the electric part accommodating space 3 of the base member 1, so that the electric part 23 can be inserted and removed through the central window 22.

The above-mentioned electric part 23 is, for example, an IC. The electric part 23 represented by the IC includes contacts 25 projecting sidewardly of the body 24.

The operating portion 16 of the contact 4 is directly pushed down by robot or finger, or otherwise a lower surface of the presser cover 21 is contacted with the operating portion of the pivotable lever 14 and the operating portion 16 is pushed down by depressing the presser cover 21 by robot or finger.

As shown in Figs. 3(B) and 4(B), by pushing down the operating portion 16, the pivotable lever 14 is pivoted downward about the shaft portion 17. Upon downward movement of the pivotable lever 14, the acting portion 15 pulls the latch portion 13 of the contact 4 outward. As a result, the contact 4 is displaced outwardly resisting the resiliency of the spring portion 7 to a position where it does not interfere with the contact 25 of the electric part 23 accommodated in the accommodating space 3. Accordingly, the electric part 23 can be inserted into the accommodating space 3 with no load and removed from the accommodating space 3 with no load.

When the downward pressure on the operating portion 16 is released, the pivotable lever 14 is pivoted upwardly by the resiliency of the spring portion 7 exerted to the acting portion 15 and then waits for the next pushing down operation. At the same time, the contact arm 11 and contact nose 12 of the contact 4 are displaced inwardly biased by the spring portion 7 and brought into contact with the upper surface of the contact 25 of the electric part 23 under pressure.

A wall 27 defining the electric part accommodating space 3 is provided with a positioning ridge 26 projecting upwardly therefrom, so that the side of the electric part's body 24 is supported by the positioning ridge 26. Further, the lower surface of the contact 25 is supported by a contact supporting surface 28 formed on the upper surface of the wall 27 at the outer side of the positioning ridge 26, and the contact nose 12 is brought into contact with the upper surface of such supported contact 25 under a downward pressure.

As shown in Figs. 3(A) and 4(B), when the electric part 23 is already removed, the contact nose 12 is in contact with the contact supporting surface 28 so that the contact 4 is not displaced inwardly by a predetermined amount or more. In other words, the contact supporting surface 28 forms a stopper for limiting the inwardly displacing amount of the contact 4. As a result, the operating portion 16 of the pivotable lever 14 is normally upwardly pivoted to a fixed position by the elasticity of the contact 4 and held in a waiting state.

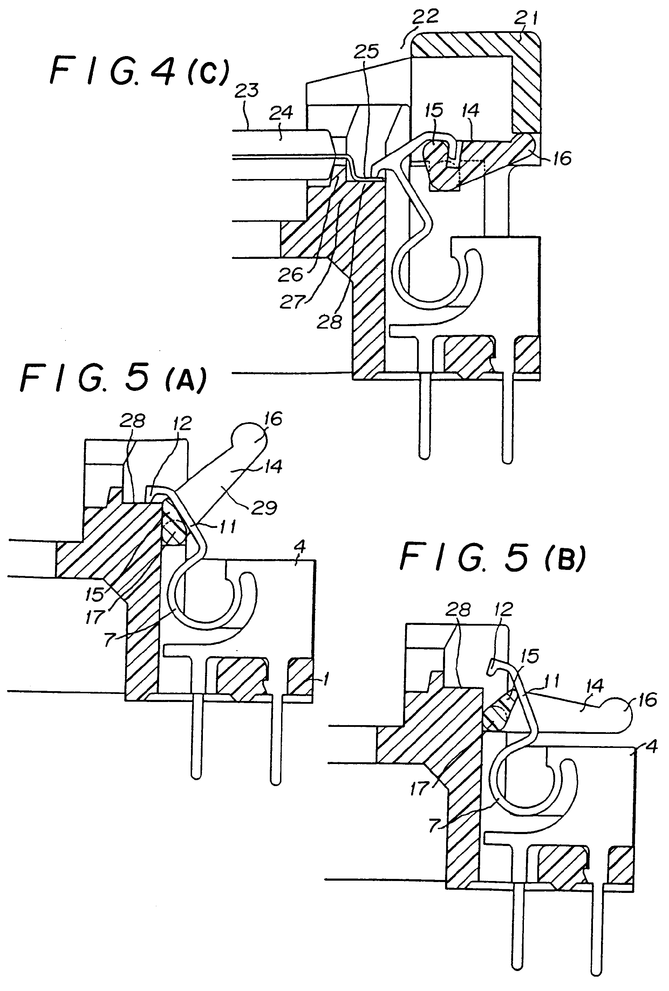

### SECOND EMBODIMENT (SEE FIGS. 5(A) and 5(B))

In an IC socket of this embodiment, the contact is not provided with the latch portion 13 as had in the first embodiment, and the acting portion 15 of the pivotable lever 14 directly exerts an outward force to the contact arm 11.

The pivotable lever 14 includes, as in the first embodiment, an acting portion 15 formed on one end thereof and extending along the row of contacts, and an operating portion 16 formed on the other end and extending along the row of contacts. The acting portion 15 is in contact with the inner surface of the contact arm 11, and the operating portion 16 is extended outwardly of the arm 11. The operating portion 16 is provided with a plurality of grooves 29 formed in the surface thereof from one end thereof to the operating portion. The grooves 29 are formed in parallel relation in the direction of the row of contacts at equal pitches as the contacts 4. The contact arms 11 of the contacts 4 are inserted into the grooves 29 in order to be elastically contacted with the operating portion 15.

The resiliency of the spring portion 7 of each contact 4 is exerted to the acting portion 15, and the contact nose 12 abutted against the supporting surface 28 holds the operating portion 16 of the pivotable lever 14 in its uppermost position. At that time, the acting portion 15 is in contact with the outer surface of the wall 27 defining the electric part accommodating space 3 by the resiliency of the spring portion 7. The pivotal fulcrum of the pivotable lever 14 formed by the shaft portion 17 is located at the inner side of the contact arm 11.

When the operating portion 16 is indirectly pushed down through the presser cover 21 or directly pushed down from the uppermost position shown in Fig. 5(A), the pivotable lever 14, as shown in Fig. 5(B), is pivoted downwardly about the shaft portion 17 to permit the acting portion 15 to exert an outward force to the contact arm 11 of the contact 4. As a result, the contact 4 is displaced outwardly against the resiliency of the spring portion 7 to separate the contact nose portion 12 away to a non-contacting position. Accordingly, in the foregoing state, the electric part 23 can be inserted and removed without being interfered with the contacts 4.

When the downward pressure of the operating portion 16 is released, the pivotable lever 14 is restored again to the state shown in Fig. 5(A) by the resiliency of the spring portion 7 and contacted with the contact 25 on the supporting surface 28.

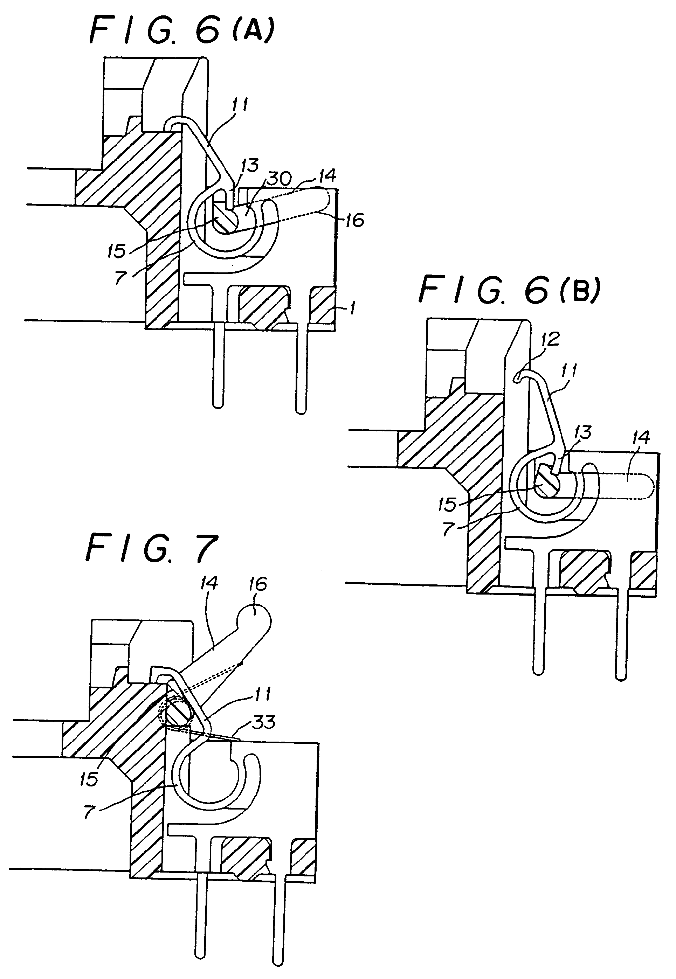

### THIRD EMBODIMENT (SEE FIGS. 6(A) and 6(B))

In this embodiment, the distal end of the curved spring portion 7 of the contact 4, in other words, the basal portion of the contact arm 4, in still other words, the connected portion between the spring portion 7 and the arm 11 is provided with a latch portion 13 projecting downward therefrom. The acting portion 15 of the pivotable lever 14 is brought into engagement with the latch portion 13. The pivotal fulcrum of the pivotable lever 14 is disposed inside the curved spring portion 7 and preferably in the vicinity of its central portion. The pivotable lever 14 is provided with a plurality of grooves 30 formed in the surface thereof at equal pitches as the contacts 4, and the flat portions of the contacts 4 and the basal portions of the spring portions 7 are received in the grooves in order to avoid an interference with the flat portions of the contacts 4 when the pivotable lever 14 is pivoted upwardly and downwardly.

This embodiment is constituted such that an outward force is exerted almost directly to the distal end portion of the spring portion 7 of the contact 4.

More specifically, when the pivotable lever 14 is pushed down, the acting portion 15 exerts an outward force to the latch portion 13 formed on the distal end of the spring portion 7 in order to directly flex the spring portion 7. At that time, the contact arm 11 is without load.

That is, when the pivotable lever 14 is pushed down from the state shown in Fig. 6(A), the outward force caused by the acting portion 15 is directly exerted to the spring portion 7 through the latch portion 13 to thereby favorably flex the spring portion 7 as shown in Fig. 6(B). As a result, the contact arm 11 is caused to be displaced outwardly with almost no load. As a result, the contact nose 12 is separated away to a non-contacting position.

### FOURTH EMBODIMENT (SEE Fig. 7)

In this embodiment, the pivotable lever 14 is resiliently held by a different spring member 33 from the spring portion 7 of the contact 4. This spring member 33 acts as a restoring means for biasing the pivotable lever 14 in a direction opposite to the pushing-down direction. For example, a forked spring is employed, and the spring member 33 is mounted on the shaft portion 17 of the pivotable lever 14 and resiliently holds the pivotable lever 14 such that the lever 14 is biased upwardly.

The pivotable lever 14 is biased upwardly by only the spring member 33, or otherwise, it may be biased upwardly by cooperative action of the spring portion 7 of the contact 4.

Although this embodiment shows an example that the spring member 33 is added to the second embodiment, the spring member 33 may be added to other embodiments.

According to the present invention, the spring portion of the contact can be set to have such a spring constant as being able to contact with the contact of the electric part with a proper contacting force. Accordingly, the contact can be freely designed without being restricted by the operating force of the pivotable lever. On the other hand, the pivotable lever can be pushed down with a reduced force in accordance with the principle of lever. Even if the spring constant of the spring portion of the contact is increased, this does not directly lead to the increase of the pushing down force. By properly setting the distances of the operating portion and acting portion from the pivotal fulcrum of the pivotable lever, the operating force can be reduced. As a result, the object for increasing the contacting force can also be achieved while realizing a reduced operating force.

Furthermore, since the acting portion of the pivotable lever exerts an external force to the contact in the direction of displacement to separate it away from the contact of the electric part, the contact can efficiently be displaced outwardly upon pushing-down operation of the pivotable lever. As a result, the electric part accommodating space can be sufficiently released.

Moreover, there can effectively be prevented a twist as had in the prior art where the cantilevered arm of a contact is depressed and an accumulation of metal fatigue in the cantilevered arm. As a result, the contact can be displaced without any problem even if it is used repeatedly.

## Claims

1. A socket for an electric part (23) including an electric part accommodating space (2), and a plurality of contacts (4) arranged in rows in parallel relation along at least two opposing sides of said space (2), said contacts each including a contact arm portion (11) to be contacted with a contact of said electric part accommodated in said electric part accommodating space under pressure, and a curved spring portion (7) for biasing said contact arm portion inwardly in order to exert a pressure contacting force to said contact arm portion (11), characterised in that said socket further includes a lever (14) pivotable about an axis parallel to one of said rows of contacts and pivotably supported along said row of contacts, an operating portion (16) formed on one end of said pivotable lever and adapted to operate said pivotable lever upwardly and downwardly, and an acting portion (13) formed on the other end thereof and adapted to exert an outward force to said contact, said acting portion (13), when said pivotable lever is pivoted downwardly by said operating portion (16), displacing said contact arm portion of said contact outwardly against the resiliency of said spring portion (7) so that the contact arm portion (11) is separated away from the contact of said electric part (23).

2. A socket for an electric part as claimed in claim 1, wherein said pivotable lever (14) is disposed in such a manner as to be pivoted outwardly of said contact arm about a fixed fulcrum (17), said contact arm portion (11) being provided with a latch portion extending outwardly from a distal end thereof, said acting portion (13) of said pivotable lever being engaged with said latch portion.

3. A socket for an electric part as claimed in claim 1, wherein the position where said acting portion (13) of said pivotable lever acts on said latch portion is set to be higher than the position of said contact portion projecting inwardly from the distal end of said contact arm portion (11).

4. A socket for an electric part as claimed in claim 1, wherein said pivotable lever (14) is resiliently held by a spring (7, 33) biasing said pivotable lever toward the uppermost pivoting position.

5. A socket for an electric part as claimed in claim 1, wherein said pivotable lever is biased to said uppermost pivoting position by said spring portion (7) of said contact.

## Patentansprüche

1. Sockel für ein elektrisches Teil (23), welcher einen das elektrische Teil aufnehmenden Raum (2) und eine Vielzahl von Kontakten (4) aufweist, die entlang wenigstens zweier gegenüberliegender Seiten des Raums (2) in Reihen mit einer parallelen Beziehung angeordnet sind, wobei jeder Kontakt ein Kontaktarmteil (11) für eine Kontaktierung unter Druck mit einem Kontakt des elektrischen Teils aufweist, das in dem das elektrische Teil aufnehmenden Raum aufgenommen ist, sowie ein gekrümmtes Federteil (7) für ein Vorspannen des Kontaktarmteils nach innen, um eine Druckkontaktierungskraft auf das Kontaktarmteil (11) auszuüben, dadurch gekennzeichnet, daß der Sockel weiterhin einen Hebel (14) aufweist, der um eine Achse parallel zu einer der Kontaktreihen schwenkbar und entlang dieser Kontaktreihe schwenkbar abgestützt ist, ein Betätigungsteil (16) an einem Ende dieses schwenkbaren Hebels ausgebildet und für eine Betätigung des schwenkbaren Hebels nach oben und nach unten angepaßt ist, und ein Wirkungsteil (13) an dessen anderem Ende ausgebildet und zur Ausübung einer auswärts wirkenden Kraft auf den Kontakt angepaßt ist, wobei das Wirkungsteil (13) das Kontaktarmteil des Kontaktes nach außen gegen die Elastizität des Federteils (7) verschiebt, wenn der schwenkbare Hebel durch das Betätigungsteil nach unten geschwenkt wird, sodaß das Kontaktarmteil (11) von dem Kontakt des elektrischen Teils (23) getrennt wird.

2. Sockel für ein elektrisches Teil nach Anspruch 1, bei welchem der schwenkbare Hebel (14) derart angeordnet ist, daß er um einen festen Drehpunkt (17) nach außen in Bezug auf den Kontaktarm geschwenkt werden kann, wobei das Kontaktarmteil (11) mit einem Klinkenteil versehen ist, welches von seinem fernen Ende nach außen verläuft, und wobei das Wirkungsteil (13) des schwenkbaren Hebels mit diesem Klinkenteil in Eingriff kommt.

3. Sockel für ein elektrisches Teil nach Anspruch 1, bei welchem die Position, in welcher das Wirkungsteil (13) des schwenkbaren Hebels auf das Klinkenteil einwirkt, höher eingestellt ist als die Position des Kontaktteils, welches von dem fernen Ende des Kontaktarmteils (11) nach innen vorsteht.

4. Sockel für ein elektrisches Teil nach Anspruch 1, bei welchem der schwenkbare Hebel (14) elastisch-federnd durch eine Feder (7, 33) gehalten wird, welche den schwenkbaren Hebel gegen die oberste Schwenkposition vorspannt.

5. Sockel für ein elektrisches Teil nach Anspruch 1, bei welchem der schwenkbare Hebel durch das Federteil (7) des Kontakts in die oberste Schwenkposition vorgespannt wird.

## Revendications

1. Douille pour pièce électrique (23), comportant un espace (2) pour la réception d'une pièce électrique et une pluralité de contacts (4) disposés en rangées parallèles le long d'au moins deux côtés opposés dudit espace (2), lesdits contacts comportant chacun une partie formant bras de contact (11) destinée à être mise en contact par pression avec un contact de ladite pièce électrique reçue dans ledit espace de réception de pièce électrique, et une partie incurvée formant ressort (7) pour rappeler vers l'intérieur ladite partie formant bras afin d'exercer une force de contact par pression sur ladite partie formant bras de contact (11), caractérisée en ce que ladite douille comporte en outre un levier (14) pouvant pivoter autour d'un axe parallèle à l'une desdites rangées de contacts et monté pivotant le long de ladite rangée de contacts, une partie d'actionnement (16) formée sur une extrémité dudit levier pivotant et adaptée à actionner ledit levier pivotant vers le haut et vers le bas, et une partie active (13) formée sur son autre extrémité et adaptée à exercer une force dirigée vers l'extérieur sur ledit contact, ladite partie active (13) produisant, lorsque ledit levier pivotant est amené à pivoter vers le bas par ladite partie active (13), un déplacement vers l'extérieur de ladite partie formant bras de contact dudit contact, en s'opposant à l'élasticité de ladite partie formant ressort (7) de façon à ce que la partie formant bras de contact (11) s'écarte du contact de ladite pièce électrique (23).

2. Douille pour pièce électrique selon la revendication 1, caractérisée en ce que ledit levier pivotant (14) est disposé de manière à pouvoir être amené à pivoter vers l'extérieur dudit bras de contact sur un point d'appui fixe (17), ladite partie formant bras de contact (11) étant pourvue d'une partie de verrouillage se prolongeant vers l'extérieur d'une extrémité éloignée de celle-ci, ladite partie de verrouillage s'engageant sur ladite partie active (13) dudit levier pivotant.

3. Douille pour pièce électrique selon la revendication 1, dans laquelle la position à laquelle ladite partie active (13) dudit levier pivotant agit sur ladite partie de verrouillage est ajustée à une hauteur supérieure à la position de ladite partie de contact faisant saillie vers l'intérieur de l'extrémité éloignée de ladite partie formant bras de contact (11).

4. Douille pour pièce électrique selon la revendication 1, dans laquelle ledit levier (14) est maintenu de façon élastique par une ressort (7, 35) rappelant ledit levier pivotant vers la position de pivotement la plus haute.

5. Douille pour pièce électrique selon la revendication 1, dans laquelle ledit levier est rappelé vers ladite position de pivotement la plus haute par ladite partie formant ressort (7) dudit contact.
